Europäisches Patentamt

European Patent Office

Office européen des brevets

(11) Publication number: **0 248 617 B1**

# EUROPEAN PATENT SPECIFICATION

(45) Date of publication of patent specification: **21.04.93**  (51) Int. Cl.5: **H05K 1/03**, C08J 9/42

(21) Application number: **87304816.9**

(22) Date of filing: **01.06.87**

(54) **Process for making substrates for printed circuit boards.**

(30) Priority: **02.06.86 JP 125855/86**
     **02.06.86 JP 125856/86**

(43) Date of publication of application:
     **09.12.87 Bulletin  87/50**

(45) Publication of the grant of the patent:
     **21.04.93 Bulletin  93/16**

(84) Designated Contracting States:
     **AT BE CH DE ES FR GB GR IT LI LU NL SE**

(56) References cited:
     **EP-A- 0 160 439**
     **DE-A- 2 945 191**
     **FR-A- 2 361 439**

     **ELECTRONICS, vol. 59, no. 22, 2nd June 1986, pages 21,24, New York, US; T. NAEGELE: "Using gore-tex reduces signal delay in PC board"**

(73) Proprietor: **JAPAN GORE-TEX, INC.**
     **42-5, 1-chome Akazutsumi**
     **Setagaya-ku Tokyo 156(JP)**

(72) Inventor: **Hatakeyama, Minoru**
     **1-22, 7-chome, Sakuragaokanishi**
     **Sanyo-cho, Akaiwa-gun Okayama-ken**
     **709-08(JP)**
     Inventor: **Komada, Ichiro**
     **159-5, Akoda**
     **Okayama City Okayama-ken 703(JP)**
     Inventor: **Moriya, Kosuke**
     **1898-55, Miyoshi**
     **Okayama City Okayama-ken 703(JP)**

(74) Representative: **Klunker . Schmitt-Nilson . Hirsch**
     **Winzererstrasse 106**
     **W-8000 München 40 (DE)**

## Description

This invention relates to a process for manufacturing substrates for printed circuit boards and the products made by that process. More particularly, it relates to a process which can be used to manufacture, from the same basic materials, a wide variety of substrates especially suited for printed circuit boards and having a low dielectric constant and electrical characteristics meeting various end-use requirements.

The various types of substrates made by the process are especially suited for printed circuit boards which meet diversified needs ranging from general electronic devices to computers requiring high-speed signal transmission.

Base materials for printed circuit boards used in conventional electronic equipment have included:

(1) Glass/epoxy or paper/epoxy composite base materials prepared by impregnating glass cloth or paper with an epoxy resin, following by curing; or paper/phenoplast base materials prepared by impregnating paper with a phenoplast resin, following by curing;

(2) Flexible insulating materials such as polyimide film and polyester film;

(3) Heat resistant base materials made of a glass fiber/polyimide composite;

(4) Low-dielectric-constant base materials, such as epoxy/Kevlar (Kevlar is a registered trade mark), polyimide/Kevlar and epoxy/quartz composites; and

(5) Low-dielectric-constant base materials composed of glass cloth and polytetrafluoroethylene.

Each of the above-mentioned materials provides final products having well defined characteristics; that is, it is impossible or impractical to manufacture products having varying characteristics from the same base material.

Materials of type (1), which are the most widely used, have relatively high dielectric constant and can usually not be applied to computers and other equipment for which processing at increasingly higher transmission speeds has been required in recent years. The same is true of the materials of types (2) and (3), which normally do not provide printed circuit boards of sufficiently low dielectric constant. The level of dielectric constant of these materials at a frequency of 1 MHz is as follows:
4.5-5.5 for (1), 3.5-5.0 for (2), 4.3.-4.7for (3)
Materials of type (4), though excellent in thermal resistance, also have a dielectric constant ranging from about 3.5 to 4.0 and normally cannot meet the need for higher speed of signal transmission.

Materials of type (5) have dielectric constant of about 2.5 to 3 and are regarded as low-dielectric-constant base materials. But their disadvantages include low adhesion to metal foil and poor workability.

All of these base materials are not only unable to meet the transmission speed requirements for computers or the like in terms of dielectric constant but also exhibit different physical property characteristics, such as thermal resistance, heat conductivity and mechanical properties and flexibility. Hence, the type of base material to be used must be selected to meet the specific requirements for each end use. Thus, manufacturers have to store many types of materials in inventory in order to satisfy a variety of needs, or they can accept orders only for a few, selected types of products.

EP-A 0 194 381, which falls under Article 54 (3) EPC and is therefore not relevant to the question of inventive step, discloses a process for making a dielectric material which is useful in a printed circuit laminated composite, the process comprising treating a fabric containing at least a portion expanded porous PTFE fibres to render them wettable by an uncured thermosetting resin, impregnating the fabric with an uncured thermosetting resin which penetrates into interstices of the fabric, heating and drying the resin impregnated fabric to cure the resin to at least the semi-cured B-stage state, wherein the process may include the step of calendring the fabric to reduce its thickness. From the EP-A 0 160 439 there is known a method of manufacturing a printed circuit board using a sheet of porous expanded PTFE containg at least one other resin within its pores.

Even when various base materials designed or manufactured in the above-mentioned way are stored in inventory, it is not always possible to meet every specific need.

According to the present invention there is provided a method of manufacturing a dielectric material using a composite sheet of porous expended PTFE containing at least one other resin within its pores, said sheet being at least partially compressed.

The sheet may be compressed that substantially all of the air is expelled from within the pores of the sheet, to provide for a variety of physical and electrical characteristics from the same base material.

Beyond that, a method of manufacturing a printed circuit board using a composite sheet of porous, expanded PTFE containing at least one other resin within its pores, said sheet being at least partially compressed, is disclosed.

The other resin may be contained within the sheet in an amount of at least 15 weight percent, based on the total weight of the sheet and the other resin, and may exceed at least 24 weight percent, based on the total weight of the sheet and the other resin. The other resin may be a thermosetting resin.

The other resin may be partially cured or fully cured. An inorganic particulate filler may be incorporated in the expanded, porous PTFE.

The composite may be laminated to a sheet of electrically conductive material such as a sheet of metal, including a sheet of cooper or a sheet of aluminum.

The other resin may be an epoxy resin, a polyimide resin, a triazine resin, a bismaleinimide/triazine resin, or a phenolic resin.

A polymeric coating may be applied over the composite to seal it from the atmosphere.

The invention will now be particularly described, by way of example, with reference to the accompanying drawings in which:-

Figure 1 is a photomicrograph showing a typical node-fibril structure of the expanded, porous PTFE used in the invention;

Figure 2 is a photomicrograph showing another node-fibril structure of biaxially expanded, porous PTFE used in the invention;

Figure 3 shows a product according to the invention having an airtight, polymeric coating thereover.

A process is provided for manufacturing a composite of a sheet of expanded, porous polytetrafluoroethylene (PTFE) impregnated with another resin, the other resin being impregnated within the pores of the expanded PTFE. The other resin imparts desired characteristics to the composite such as high thermal resistance and low dielectric constant which make it useful as substrates for printed circuit boards. The composite is useful as a dielectric generally and as an adhesive.

In particular, a process for manufacturing substrates for printed circuit boards is provided which comprises using porous, expanded PTFE as a base material, impregnating the porous base material with a resin solution that will give characteristics (thermal resistance, low dielectric constant, etc.) required for intended circuit boards, and curing said resin under pressure conditions that will give the intended characteristics.

Expanded, porous PTFE has a dielectric constant as low as about 1.1 to 1.8, and can be readily impregnated with suitable resin solutions because of its porous structure, although PTFE itself is chemically very stable and is difficult to bond to other types of resins or adhesives.

The electrical, physical and chemical properties of the resin solution used for impregnation according to the invention are the primary factors that determine the characteristics of the resulting composites.

A second factor that determines the characteristics of the composites is the pressure conditions adopted for curing of the resin-impregnated, porous base material.

Substrates for printed circuit boards having widely different electrical, physical and chemical characteristics can be manufactured from the same base material by properly combining these two factors.

Characteristics required for printed circuit boards used in electrical equipment are very diverse. For example, ultra-high-speed processing elements based on gallium arsenide and other relatively new materials have been developed to meet the need for high-speed signal transmission in computers, and there is a great demand also for printed circuit boards having characteristics that match this need. On the other hand, substrates to which IC chips are to be directly attached are frequently required to have, in combination, adequate thermal expansion coefficient, heat conductivity and mechanical strength, as well as low dielectric constant.

The signal transmission delay time, $\tau$, as in high-speed computers, is proportional to the square root of the dielectric constant of the material used, and may be represented by the following formula in a strip line:

$$\tau = \sqrt{\epsilon}\,/C \ (nsec/m)$$

wherein $\epsilon$ is the dielectric constant of the material and C is the velocity of light ($3\times10^{8}$ m/sec). Therefore, materials having low dielectric constant usually must be used in order to provide for higher speeds of signal transmission.

With substrates to which IC chips are to be directly attached, on the contrary, priority normally should be given to, in combination, adequate thermal expansion coefficient, heat conductivity and mechanical strength, even at the sacrifice of dielectric constant to a certain extent.

This invention meets the various needs for substrates for printed circuit boards as described above. Polytetrafluoroethylene itself has a very low dielectric constant, and hence its porous products also possess a value as low as 1.2, even at a porosity of 80%. This resin, however, is rather poor in resistance to tensile and compressive forces. These disadvantages of polytetrafluoroethylene can be avoided by the use of porous, expanded products thereof and by impregnation with a resin of another type, followed by curing of the impregnated resin.

Previously known porous, expanded PTFE impregnated with a resin of low dielectric constant or high thermal resistance, thus obtained, still normally contains a considerable volume of pores. As a result, the etching solution can work into these pores, thereby etching unintended areas. Part of the components of the etching solution is unavoidably left attached to the base material and moisture tends to work into these pores during service of the resulting printed circuit boards, thus adversely affecting their insulating and dielectric characteristics. In the process of this invention, these difficulties are avoided by effecting pressure curing. However, the dielectric constant tends to increase as the porosity is decreased by this press forming process.

This means that final products having different dielectric constant, insulating characteristics, flexibility, mechanical strength and other properties can be obtained, even when the same type of resin is used for impregnation, by performing the compression operation under different pressures, followed by curing.

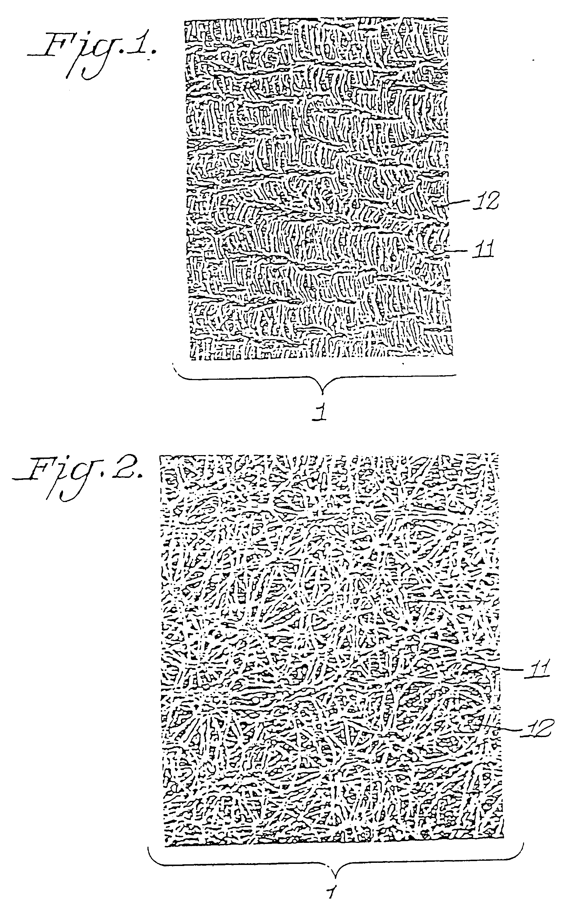

As shown in Figs. 1 and 2, the porous, expanded polytetrafluoroethylene 1 used in the process of this invention can be obtained by rolling and stretching polytetrafluoroethylene film as disclosed in U.S. Patent 3,953,566 in the form of minute fibers 12 intertwined with one another between nodes 11 like a spider web. Several sheets of such porous, expanded resin may be laminated one upon another, as required, to give base materials with a porosity ranging from 30 to 90%. The dielectric constant decreases with increasing porosity, which ranges from about 1.1 to 1.8 for the range of porosities mentioned above.

The resins to be impregnated into the porous polytetrafluoroethylene include heat-resistant resins as follows:

epoxy, polyimide, triazine and bismaleinimide/triazine resins.

The porous polytetrafluoroethylene thus impregnated with a resin solution may then be subjected to a pressure curing operation under different conditions appropriate to the intended characteristics of printed circuit boards. For example, press forming is conducted under mild conditions when low dielectric constant is intended, whereas higher pressure conditions are adopted when priority is given to insulating charactertistics. If a press or rollers are used to effect the pressure curing, the porous structure will be moderately altered and the porosity of the resulting base material will be lower. Electrical and mechanical characteristics, as well as dimensional stability, of final products will be determined by the pressure conditions adopted.

In a base material obtained as described above, incorporating an inorganic substance, such as SiC, $SiO_2$ and quartz powder, into the polytetrafluoroethylene further enhances its heat conductivity, dimensional stability and mechanical strength.

In addition, providing a heat-conductive material, such as a soft or rigid metal foil, can allow effective dissipation of heat generated during the service life of printed circuit boards. Use of a soft metal material, in particular, gives flexible boards that can be deformed as desired.

When forming a conductive circuit on the base material obtained above by using metal foil (e.g., copper), an adhesive may be used for its bonding if the impregnated resin is poor in adhesion to that metal foil. Conductive circuits may also be formed by ion plating, vacuum deposition or spattering methods, in addition to a plating process using a plating catalyst layer.

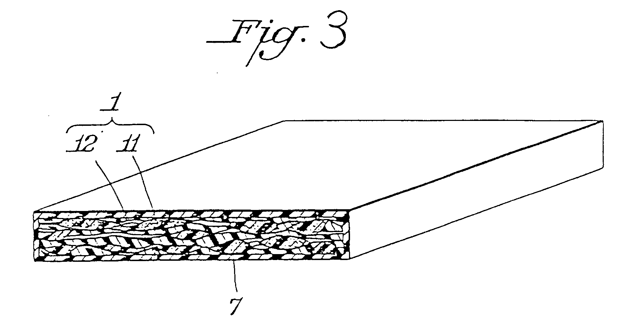

The base materials for printed circuit boards manufactured according to the process of this invention may have a certain degree of porosity. When polymeric coatings 7 are provided on both sides as shown in Fig. 3, application of a resin solution around the edges makes the structure airtight, thereby preventing entry of air, moisture and etching solution to avoid lowering of insulating and dielectric characteristics and enabling etching of fine circuit patterns.

## Manufacturing Example 1

A sheet of porous, expanded polytetrafluoroethylene film 1 having a thickness of 0.1 mm and a porosity of 70% was impregnated with 40 weight percent of an epoxy resin as described above. After drying and curing the impregnated resin by press forming to a thickness of 0.08 mm, copper foil was bonded to both sides of the film. The final product obtained had a dielectric constant as low as 2.2, and was found suitable for use as a printed circuit board in high-speed computers.

## Manufacturing Example 2

The same type of 1 mm thick, porous, expanded polytetrafluoroethylene film as used in Example 1, also containing 50 weight percent of quartz powder 4 to 8 $\mu$m in particle size, was impregnated with 30 weight percent of an epoxy resin. After drying and curing the impregnated resin by press forming to a thickness of 0.09 mm, copper foil was laminated onto both sides of the film. The final product thus obtained had a dielectric constant of 2.2 and high heat conductivity and was found suitable for use in high-speed computers.

As is apparent from the foregoing, the process of this invention can be used to manufacture substrates for printed circuit boards having varying characteristics from the same material, i.e. porous expanded, polytetrafluoroethylene. This process assures manufacturers easier management of raw materials and allows them to flexibly respond to diversified needs.

## Claims

1. The method of manufacturing a dielectric material using a composite sheet of porous expanded PTFE (1) containing at least one other resin within its pores, said sheet being at least partially compressed.

2. The method of claim 1 wherein said sheet is completely compressed such that substantially all air is expelled from within the pores of said sheet.

3. The method of claim 1 wherein said other resin is contained within said sheet in an amount of at least 15 weight percent, based on the total weight of said sheet and said other resin.

4. The method of claim 1 wherein said other resin is contained within said sheet in an amount of at least 24 weight percent, based on the total weight of said sheet and said other resin.

5. The method of claim 1 wherein said other resin is a thermosetting resin.

6. The method of claim 1 wherein said other resin is partially cured.

7. The method of claim 1 wherein said other resin is fully cured.

8. The method of claim 1 wherein an inorganic particulate filler is incorporated in said expanded, porous PTFE (1).

9. The method of claim 1 wherein said composite is laminated to a sheet of electrically conductive material.

10. The method of claim 9 wherein said conductive material is metal.

11. The method of claim 10, wherein said metal is copper.

12. The method of claim 10 wherein said metal is aluminum.

13. The method of claim 1 wherein said other resin is an epoxy resin.

14. The method of claim 1 wherein said other resin is a polyimide resin.

15. The method of claim 1 wherein said other resin is a triazine resin.

16. The method of claim 1 wherein said other resin is a bismaleinimide/triazine resin.

17. The method of claim 1 wherein said other resin is a phenolic resin.

18. The method of claim 1 wherein said composite has a polymeric coating (7) thereover.

19. The method of manufacturing a printed circuit board using a composite sheet of porous, expanded PTFE (1) containing at least one other resin within its pores, said sheet being at least partially compressed.

## Patentansprüche

1. Verfahren zum Herstellen eines dielektrischen Materials unter Verwendung einer Verbundfolie aus porösem, expandiertem PTFE (1), die in ihren Poren zumindest ein anderes Harz enthält, wobei die Folie zumindest teilweise zusammengepreßt ist.

2. Verfahren nach Anspruch 1, bei dem die Folie vollständig derart zusammengepreßt ist, daß praktisch sämtliche Luft aus den Poren der Folie ausgetrieben ist.

3. Verfahren nach Anspruch 1, bei dem das andere Harz in der Folie in einer Menge von mindestens 15 Gew.-% enthalten ist, bezogen auf das Gesamtgewicht der Folie und des weiteren Harzes.

4. Verfahren nach Anspruch 1, bei dem das weitere Harz in der Folie in einer Menge von mindestens 24 Gew.-% enthalten ist, bezogen auf das Gesamtgewicht der Folie und des weiteren Harzes.

5. Verfahren nach Anspruch 1, bei dem das weitere Harz ein hitzehärtbares Harz ist.

6. Verfahren nach Anspruch 1, bei dem das weitere Harz teilweise ausgehärtet ist.

7. Verfahren nach Anspruch 1, bei dem das weitere Harz vollständig ausgehärtet ist.

8. Verfahren nach Anspruch 1, bei dem ein anorganischer teilchenförmiger Füllstoff in das expandierte, poröse PTFE (1) eingebracht wird.

9. Verfahren nach Anspruch 1, bei dem der Verbundstoff zu einer Folie aus elektrisch leitendem Material laminiert ist.

**10.** Verfahren nach Anspruch 9, bei dem das leitende Material Metall ist.

**11.** Verfahren nach Anspruch 10, bei dem das Metall Kupfer ist.

**12.** Verfahren nach Anspruch 10, bei dem das Metall Aluminium ist.

**13.** Verfahren nach Anspruch 1, bei dem das weitere Harz ein Epoxyharz ist.

**14.** Verfahren nach Anspruch 1, bei dem das weitere Harz ein Polyimidharz ist.

**15.** Verfahren nach Anspruch 1, bei dem das weitere Harz ein Triazinharz ist.

**16.** Verfahren nach Anspruch 1, bei dem das weitere Harz ein Bismaleinimid-Triazin-Harz ist.

**17.** Verfahren nach Anspruch 1, bei dem das weitere Harz ein Phenolharz ist.

**18.** Verfahren nach Anspruch 1, bei dem der Verbundstoff mit einem Polymer-Überzug (7) versehen ist.

**19.** Verfahren zum Herstellen einer gedruckten Schaltungsplatine unter Verwendung einer Verbundfolie aus porösem, expandiertem PTFE (1), die in ihren Poren zumindest ein weiteres Harz enthält, wobei die Folie zumindest teilweise zusammengepreßt ist.

**Revendications**

**1.** Procédé de fabrication d'un matériau diélectrique utilisant une feuille composite de PTFE poreux expansé (1) contenant au moins une autre résine dans ses pores, ladite feuille étant au moins partiellement comprimée.

**2.** Procédé selon la revendication 1, dans lequel ladite feuille est totalement comprimée de sorte que sensiblement tout l'air est expulsé de l'intérieur des porcs de ladite feuille.

**3.** Procédé selon la revendication 1, dans lequel ladite autre résine est contenue dans ladite feuille en une quantité d'au moins 15 % en poids, par rapport au poids total de ladite feuille et de ladite autre résine.

**4.** Procédé selon la revendication 1, dans lequel ladite autre résine est contenue à l'intérieur de ladite feuille en une quantité d'au moins 24 % en poids, par rapport au poids total de ladite feuille et de ladite autre résine.

**5.** Procédé selon la revendication 1, dans lequel ladite autre résine est une résine thermodurcissable.

**6.** Procédé selon la revendication 1, dans lequel ladite autre résine est partiellement durcie.

**7.** Procédé selon la revendication 1, dans lequel ladite autre résine est totalement durcie.

**8.** Procédé selon la revendication 1, dans lequel une charge minérale particulaire est incorporée dans ledit PTFE poreux expansé (1).

**9.** Procédé selon la revendication 1, dans lequel ledit matériau composite est laminé sur une feuille d'un matériau conducteur de l'électricité.

**10.** Procédé selon la revendication 9, dans lequel ledit matériau conducteur est un métal.

**11.** Procédé selon la revendication 10, dans lequel ledit métal est du cuivre.

**12.** Procédé selon la revendication 10, dans lequel ledit métal est de l'aluminium.

**13.** Procédé selon la revendication 1, dans lequel ladite autre résine est une résine époxy.

**14.** Procédé selon la revendication 1, dans lequel ladite autre résine est une résine de polyimide.

**15.** Procédé selon la revendication 1, dans lequel ladite autre résine est une résine de triazine.

**16.** Procédé selon la revendication 1, dans lequel ladite autre résine est une résine de bismaléine-imide/triazine.

**17.** Procédé selon la revendication 1, dans lequel ladite autre résine est une résine phénolique.

**18.** Procédé selon la revendication 1, dans lequel ledit matériau composite est recouvert d'un revêtement polymère (7).

**19.** Procédé de fabrication d'une plaquette à circuits imprimés utilisant une feuille composite de PTFE poreux expansé (1) contenant au moins une autre résine dans ses pores, ladite feuille étant au moins partiellement comprimée.

Fig.1.

Fig.2.

*Fig. 3*